Europäisches Patentamt

European Patent Office

Office européen des brevets

(19)

(11) Veröffentlichungsnummer: **0 213 470**
B1

(12) **EUROPÄISCHE PATENTSCHRIFT**

(45) Veröffentlichungstag der Patentschrift:
20.12.89

(21) Anmeldenummer: 86111091.4

(22) Anmeldetag: 11.08.86

(51) Int. Cl.⁴: **B28B 3/08,** B28B 3/00,
B28B 13/02, B28B 7/38,
H01L 41/22

(54) Verfahren und Vorrichtung zum Fertigen von piezokeramischen Membranen.

(30) Priorität: 21.08.85 DE 3529922

(43) Veröffentlichungstag der Anmeldung:
11.03.87 Patentblatt 87/11

(45) Bekanntmachung des Hinweises auf die Patenterteilung:
20.12.89 Patentblatt 89/51

(84) Benannte Vertragsstaaten:
AT CH DE FR GB IT LI NL SE

(56) Entgegenhaltungen:
DE-A- 2 913 829
DE-B- 1 090 561
DE-C- 809 055
FR-A- 2 554 758
GB-A- 1 041 333

CERAMIC BULLETIN, Band 58, Nr. 5, 1979,
Seiten 516-518,521; J.V. BIGGERS et al.: "Densification
of PZT cast tape by pressing"
"SPRECHSAAL", Vol. 118, Nr. 7 (1985), S. 601 bis 605 -
konstruieren mit Keramik-Gestaltung von einachsig
gepressten Bauteilen

(73) Patentinhaber: Siemens Aktiengesellschaft,
Wittelsbacherplatz 2, D-8000 München 2(DE)

(72) Erfinder: Dlugosch, Dieter, St. Gundekar Strasse 23a,
D-8807 Heilsbronn(DE)

ACTORUM AG

## Beschreibung

Die Erfindung bezieht sich auf ein Verfahren zum Fertigen von piezokeramischen Membranen, bei dem pulverförmige keramische Ausgangsmaterialien einer Formgebung zu einem Rohling mit für Membranen typischem Verhältnis von Dicke zu Fläche mit einer Dicke von unter 200 μm unterzogen werden und anschließend durch Wärmebehandlung gesintert und durch Umsatzbrand in den piezokeramischen Zustand überführt werden, welcher Rohling als Membran einsetzbar ist. Daneben bezieht sich die Erfindung auf die zugehörige Vorrichtung zur Durchführung des Verfahrens.

Beispielsweise für Fernsprechanlagen od. dgl. werden piezokeramische Membranen benötigt. Membranen sind dünne, flächenhafte Körper, die an ihrem Rand eingespannt sind und somit schwingfähige Gebilde darstellen. Solche Membranen haben durchweg eine Dicke von weniger als 200 μm, beispielsweise zwischen 80 μm und 160 μm, und bestehen speziell aus Mischungen von Bleioxiden, Titanoxiden und Zirkonoxiden, die durch einen Umsatzbrand piezoelektrischen Charakter bekommen.

Bisher wurden die flächenhaften Körper der Membranen aus Piezokeramik für obige Anwendungszwecke aus einer aufgeschlämmten, wässrigen Lösung, dem sogenannten Schlicker, als Folien gegossen. Diese Folien werden im Ofen getrocknet und anschließend die entsprechenden Durchmesser als Rohlinge für die einzelnen Membranen ausgestanzt. Die Einhaltung der geforderten Foliendicke sowie deren Parallelität ist problematisch, da sie von der Viskosität des Schlickers sowie von der Ebenheit des Transportbandes abhängen. Diese Probleme sind trotz hohem regeltechnischen Aufwand nur schwer beherrschbar und bis heute nicht gelöst.

Weiterhin werden beim sogenannten Schlickerverfahren die gesamten Folien mit zusätzlichem Zirkonoxid beschichtet, was zur Folge hat, daß der Stanzabfall sowie auch der Ausschuß nicht wieder als Rohstoff verwendbar ist. Bei den bisherigen Fertigungstechnologien konnte daher das Rohmaterial teilweise nur zu einem Drittel ausgenutzt werden.

Aus der DE-A 2 913 829 ist ein Verfahren zum Pressen von Pulvern zu Formteilen bekannt, bei dem der Preßvorgang in einer Ringmatrize mit separat steuerbarem Oberstempel und Unterstempel durchgeführt wird. Dabei soll bei abgesenktem Unterstempel mittels eines Füllschuhs die Ringmatrize gefüllt, anschließend der Unterstempel weiter nach unten gefahren werden und dann durch beidseitigen Druck das Pressen erfolgen. Nach dem Pressen sollen Unterstempel und Oberstempel zunächst synchron aus der Matrize herausbewegt werden, worauf erst dann das Entformen erfolgt. über die Art und Größe der Formteile sind in der DE-A 2 913 829 keine Aussagen gemacht. Speziell für das Pressen von Keramik-Formteilen ist es aber der Fachwelt hinlänglich bekannt, daß das Trockenpressen von flächenhaft ausgedehnten Körpern nur unter Schwierigkeiten möglich ist. Speziell in der Literaturveröffentlichung "SPRECHSAAL, Vol. 118, Nr. 7 (1985), S. 601 bis 605" mit der Bezeichnung "Konstruieren mit Keramik — Gestaltung von einachsig gepreßten Bauteilen", wird speziell auf Seite 603 mittlere Spalte, drittletzter Absatz darauf hingewiesen, daß die minimale Höhe von preßbaren Teilen stark vom Verhältnis der Höhe zum Durchmesser des Teils abhängt und daß insbesondere Teile mit der absoluten Dicke von weniger als 1 mm nicht mehr durch einachsiges Pressen herstellbar sind. Teile derartiger Dimensionierung werden aber als Rohlinge für Membranen benötigt.

Aufgabe der Erfindung ist es demgegenüber, ein neues Herstellungsverfahren und eine zugehörige Vorrichtung anzugeben, mit denen piezokeramische Membranen besser zu fertigen sind.

Im Rahmen vorliegender Erfindung wird die Aufgabe dadurch gelöst, daß das Fertigungsverfahren der eingangs genannten Art mit der Maßgabe folgender Merkmale bei Herstellung des Rohlinges durchgeführt wird:

– Die Herstellung erfolgt durch Pressen des pulverförmigen Ausgangsmaterials in einer Preßeinrichtung aus Preßmatrize sowie relativ dazu verschiebbaren Unterstempel und Oberstempel, wobei

a) ein volumetrisches Einfüllen des Ausgangsmaterials bei abgesenktem Unterstempel und Einebnen des Pulvers auf konstante Höhe erfolgt,
b) anschließend die Schicht vorgegebener Höhe des Ausgangspulvers unter vorgegebenem Druck gepreßt wird,
c) zum Entformen des Membranrohlings Unterstempel und Oberstempel im gepreßten Zustand sychron relativ zur Preßmatrize verschoben und erst anschließend Oberstempel und Unterstempel auseinander bewegt werden.

Mit der Erfindung gelingt es nun erstmalig, zur Herstellung von dünnen piezokeramischen Membranen ein Trockenpressen für die Rohlinge, die einen flächenhaften Körper mit für die Membran typischen Verhältnis von Dicke zu Fläche mit einer Dicke unter 200 μm, beispielsweise zwischen 80 und 160 μm, bilden, anzuwenden. Vorzugsweise kann dabei das Einfüllen des Ausgangsmaterials bereits mit konstanter Füllhöhe erfolgen; insbesondere erfolgt aber ein Einebnen des Ausgangsmaterials durch zumindest zweimaliges Abstreifen in gegenläufigen Richtungen. Vorzugsweise werden vor dem volumetrischen Einfüllen des Pulvers Gleitmittel auf die Preßflächen von Oberstempel und Unterstempel aufgetragen. Für den eigentlichen Preßvorgang gemäß dem Teilschritt b) wird die gefüllte Preßmatrize abgesenkt, der Oberstempel zunächst bis zum Matrizenrand bewegt und der weitere Vorschub erfolgt mit verringerter Geschwindigkeit. Beim Preßvorgang liegt der Preßdruck vorteilhafterweise zwischen 0,5 und 2 t/cm² und die Preßzeit zwischen einer halben und 3 Sekunden. Im einzelnen werden Preßdruck und Preßzeit aufeinander abgestimmt.

Die zugehörige Vorrichtung zur Durchführung des Verfahrens macht Gebrauch von einer Pulverpresse aus Preßmatrize mit relativ gegeneinander bewegbarem Unterstempel und Oberstempel, wie sie an sich aus der Pulvermetallurgie bekannt ist. Dabei ist die Preßmatrize als eine Ringmatrize ausgebildet und weist eine Fülleinrichtung, mit der eine volumetrische Füllung der Ringmatrize bei abgesenktem Unterstempel auf gleichmäßige Höhe möglich ist, und/oder ein gegebenenfalls separates Abstreif-Lineal zur Verteilung des eingefüllten Pulvers auf. Für die Preßqualität der Rohlinge ist es von entscheidender Bedeutung, daß Preßflächen eine Oberflächenrauhigkeit, vorzugsweise zwischen 4 und 9 µm $R_t$, aufweist. Dabei sind vorteilhafterweise die Preßflächen von Oberstempel und Unterstempel mit Mitteln zum Gleiten des Keramikpulvers versehen. Vorteilhaft ist das Gleitmittel ein sogenanntes Rüböl, das jeweils vor dem Preßvorgang aufgetragen wird. Das Gleitmittel kann aber auch eine Hartstoffschicht sein, die permanent auf den Preßflächen vorhanden ist. Das Abstreif-Lineal ist insbesondere durch ein Haar-Lineal gebildet, das vorteilhafterweise aus einem Rohr mit kreisförmiger Linealkante besteht, welches eine rotierende Bewegung um die Matrize ausführt. Sehr geeignet haben sich auch zwei konzentrische Doppelrohre erwiesen, bei denen der Abstand der Rohrwandungen klein gegenüber dem Durchmesser ist.

Weitere Vorteile und Einzelheiten der Erfindung ergeben sich aus der nachfolgenden Figurenbeschreibung eines Ausführungsbeispieles anhand der Zeichnung in Verbindung mit den Unteransprüchen.

Es zeigen die

FIG 1 schematisch eine verwendete Preßeinrichtung in Seitenansicht,
FIG 2 deren Draufsicht, wobei der Vorgang des Einebnens dargestellt wird sowie die
Figuren 3 bis 5 die Verfahrensschritte des Pressens, sowie des Entformens in zwei unterschiedlichen Phasen entsprechend der in FIG 1 dargestellten Preßeinrichtung.

Zunächst werden die Figuren zusammen beschrieben und nachfolgend der Fertigungsvorgang dargestellt.

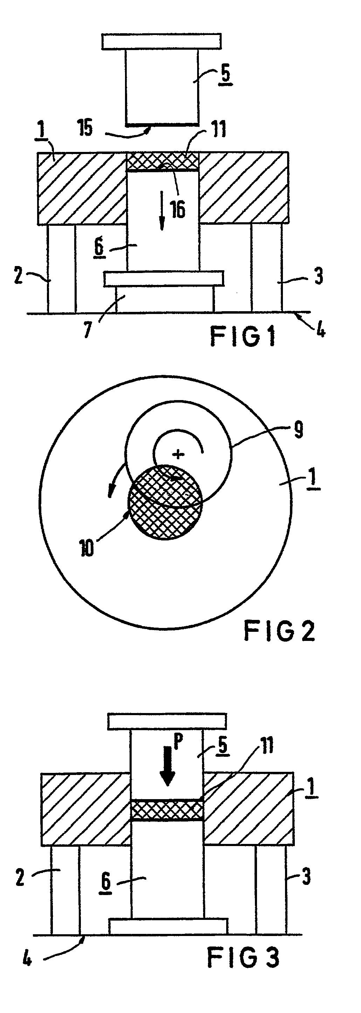

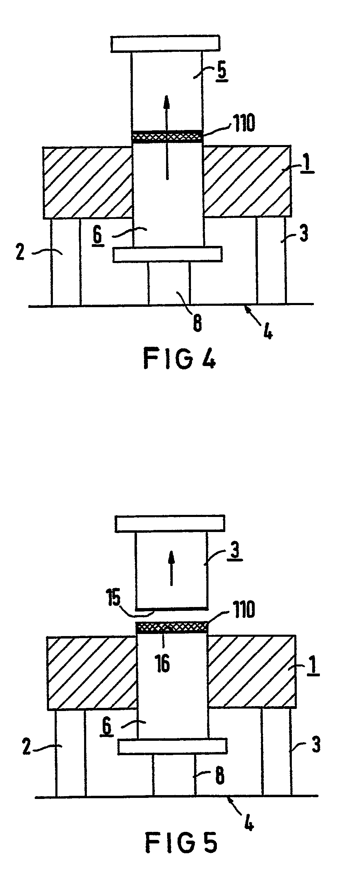

In den Figuren 1 sowie 3 bis 5 ist eine Ringmatrize 1 dargestellt, welche auf Stützen 2 und 3 auf einem Werkzeuggestell 4, das lediglich durch einen horizontalen Strich angedeutet ist, exakt waagerecht gelagert ist. Mit 5 sind ein Oberstempel und mit 6 ein Unterstempel bezeichnet, welche in senkrechter Richtung frei beweglich sind. In FIG 1 bedeutet 7 ein geschliffener Klotz als Füllhöhenleiste zwecks Füllhöhenfestlegung der Membranen; in FIG 4 und 5 kennzeichnet 8 einen entsprechend geschliffenen Klotz als Entformungsleiste.

Für die Fertigung von Telefonmembranen hat sich in der Praxis beispielsweise eine Ringmatrize 1 mit einer Bohrungsöffnung von 53 mm Durchmesser bewährt, wobei die Stützleisten 2 und 3 zweckmäßigerweise eine Höhe von 80 mm und die Füllhöhenleiste eine Höhe von 24,5 mm haben. Damit ergibt sich ein Füllraum von 0,6 mm, was einer fertiggepreßten Membran von 170 µm Stärke entspricht. Für dünnere bzw. dickere Membranen muß die Füllhöhenleiste 3 vergrößert bzw. verkleinert werden.

In der Draufsicht nach FIG 2 ist zusätzlich als Abstreiflineal ein Rohr 9 als Haar-Lineal angeordnet, das kreisende Bewegungen durchführen kann und somit das Einebnen des Pulvers durch mehrmaliges Abstreifen in gegenläufige Richtungen ermöglicht. Das Rohr 9 hat einen größeren Durchmesser als der Matrizenfüllraum, wobei der Mittelpunkt bei der Rotationsbewegung außerhalb des Füllraumes liegen muß.

Statt eines einzigen Rohres kann vorteilhaft ein Doppelrohr aus konzentrischen Einzelrohren verwendet werden, bei dem der Abstand der Rohrwandungen klein gegen die Durchmesser ist. Dabei dient das innere Rohr als Vorratsbehälter für überschüssiges Pulver und übernimmt das äußere Rohr die Abstreiffunktion des Haar-Lineals.

Daneben ist auch möglich, aus der Pulvermetallurgie bekannte Fülleinrichtungen derart zu modifizieren, daß gegebenenfalls das Füllen und Abstreifen in einem einzigen Arbeitsgang gewährleistet wird.

Zum Fertigen von Membranen durch Pressen von Keramikpulver wird folgendermaßen vorgegangen:

Als Ausgangsmaterial wurde sprühgetrocknetes, piezokeramisches Pulver einer mittleren Korngröße von 12 µm verwendet. Beispielsweise kommt als Rohmaterial ein Gemisch von Titanoxid, Bleioxid und Zirkonoxid in Frage, das durch einen Umsetzbrand die piezokeramischen Eigenschaften annimmt und die Strukturformel $(Pb(Zr_xTi_{x-1})O_3)$ hat. Vor dem Pressen werden die Stirnseiten 15 und 16 vom Oberstempel 5 und Unterstempel 6, d.h. die wirksamen Preßflächen, mit einem Gleitmittel beschichtet. Dafür wird vorteilhafterweise ein sogenanntes Rüböl verwendet, was aus bekannten organischen Komponenten besteht. Statt der separaten Beschichtung mit Rüböl für jeden Preßvorgang können die Preßflächen 15 und 16 ggf. auch mit geeigneten Hartstoffschichten versehen sein.

Zum Einfüllen wird mit Hilfe des geschliffenen Klotzes 7 die volumetrische Füllhöhe eingestellt. Zum Befüllen der Preßkavität 10 wird Keramikpulver 11 mit einem Spatel in den Matrizenfüllraum gegeben und anschließend mit dem Haar-Lineal 9 verteilt und eingeebnet. Dabei erfolgt das Abstreifen zumindest in zwei gegenläufige Richtungen. Alternativ dazu kann mit einer geeigneten Fülleinrichtung bereits ein volumetrisches Einfüllen des Keramikpulvers mit konstanter Füllhöhe erfolgen.

Anschließend wird der Unterstempel 6 mit dem Keramikpulver bis in die Mitte der Matrize 1 in die Preßposition abgesenkt. Damit ist ein Verwehen des Pulvers beim Eintauchen des Oberstempels 5 in die Matrize 1 verhindert. Der Oberstempel 5 wird nun mit deutlich verringerter Geschwindigkeit in die Matrize 1 eingefahren und bei Erreichen der Preßposition wird das Pulver mit dem eingestellten Druck, beispielsweise 1,2 t/cm², ca. 2 Sekunden lang gepreßt.

Nach dem eigentlichen Preßvorgang wird die Druckbeaufschlagung der Presse beendet, wobei der Oberstempel 5 zunächst in der Matrize 1 verbleibt. Nun wird der Unterstempel 6 und Oberstempel 7 synchron mit der gepreßten Membrane 110 soweit aus der Matrize 1 bewegt, bis sich die Oberkante des Unterstempels ca. 2 mm über dem oberen Rand der Matrize 1 befindet. Jetzt wird der Oberstempel 5 mit einer Geschwindigkeit $\leq$ 1 mm/s abgehoben, wonach die gepreßte Membran vom Unterstempel 6 abgenommen werden kann.

Es hat sich gezeigt, daß mit einem derartigen Fertigungsvorgang Membranen vorgebbarer Dicke und guter Parallelität zu erreichen sind. Die Membranen sind im gepreßten Zustand handhabbar und können so im Stapel dem Fertigbrand zugeführt werden.

## Patentansprüche

1. Verfahren zum Fertigen von piezokeramischen Membranen, bei dem pulverförmige keramische Ausgangsmaterialien einer Formgebung zu einem Rohling mit für Membranen typischem Verhältnis von Dicke zu Fläche mit einer Dicke von unter 200 μm unterzogen werden und anschließend durch Wärmebehandlung gesintert und durch Umsatzbrand in den piezokeramischen Zustand überführt werden, welcher Rohling als Membran einsetzbar ist, mit der Naßgabe folgender Merkmale bei Herstellung des Rohlings:
– Die Herstellung erfolgt durch Pressen des pulverförmigen Ausgangsmaterials in einer Preßeinrichtung aus Preßmatrize sowie relativ dazu verschiebbaren Unterstempel und Oberstempel, wobei

a) ein volumetrisches Einfüllen des Ausgangsmaterials bei abgesenktem Unterstempel und Einebnen des Pulvers auf konstante Höhe erfolgt,
b) anschließend die Schicht vorgegebener Höhe des Ausgangspulvers unter vorgegebenem Druck gepreßt wird,
c) zum Entformen des Membranrohlings Unterstempel und Oberstempel im gepreßten Zustand synchron relativ zur Preßmatrize verschoben und erst anschließend Oberstempel und Unterstempel auseinander bewegt werden.

2. Verfahren nach Anspruch 1, dadurch gekennzeichnet, daß das Einebnen des Ausgangsmaterials durch zumindest zweimaliges Abstreifen in gegenläufigen Richtungen erfolgt.

3. Verfahren nach Anspruch 1, dadurch gekennzeichnet, daß das Einfüllen des Ausgangsmaterials bereits mit konstanter Füllhöhe erfolgt.

4. Verfahren nach Anspruch 1, dadurch gekennzeichnet, daß vor dem volumetrischen Einfüllen des Pulvers Gleitmittel auf die Preßflächen von Oberstempel und Unterstempel aufgebracht werden.

5. Verfahren nach Anspruch 1, dadurch gekennzeichnet, daß für den Preßvorgang die gefüllte Preßmatrize abgesenkt wird, der Oberstempel zunächst bis zum Matrizenrand bewegt und der weitere Vorschub bis zur Preßstellung mit verringerter Geschwindigkeit erfolgt.

6. Verfahren nach Anspruch 1, dadurch gekennzeichnet daß beim Preßvorgang der Preßdruck zwischen 0,5 und 2t/cm² und die Preßzeit zwischen 0,5 und 3 Sekunden liegt.

7. Verfahren nach Anspruch 6, dadurch gekennzeichnet, daß Preßdruck und Preßzeit aufeinander abgestimmt werden.

8. Verfahren nach Anspruch 1, dadurch gekennzeichnet, daß bei Verfahrensschritt b) das Abheben des Oberstempels von der Membran mit einer Geschwindigkeit $\leq$ 1 mm/s erfolgt.

9. Vorrichtung zur Durchführung des Fertigungsverfahrens nach Anspruch 1 oder einem der Ansprüche 2 bis 8, mit einer Pulverpresse aus Preßmatrize und relativ gegeneinander bewegbaren Unterstempel (6) und Oberstempel (7), wobei die Preßmatrize als eine Ringmatrize (1) ausgebildet ist und eine Fülleinrichtung (7), mit der eine volumetrische Füllung der Ringmatrize (1) bei abgesenktem Unterstempel auf gleichmäßige Höhe möglich ist, und/oder ein gegebenenfalls separates Abstreif-Lineal (9) zur Verteilung des eingefüllten Pulvers aufweist.

10. Vorrichtung nach Anspruch 9, dadurch gekennzeichnet, daß die Preßflächen (15, 16) eine Oberflächenrauhigkeit zwischen 4 und 9 μm $R_t$ haben.

11. Vorrichtung nach Anspruch 9, dadurch gekennzeichnet, daß die Preßflächen (15, 16) von Ober- und Unterstempel (5, 6) mit Mitteln zum Gleiten des Pulvers versehen sind.

12. Vorrichtung nach Anspruch 11, dadurch gekennzeichnet, daß das Gleitmittel ein Rüböl ist.

13. Vorrichtung nach Anspruch 11, dadurch gekennzeichnet, daß das Gleitmittel eine Hartstoffschicht ist.

14. Vorrichtung nach Anspruch 9, dadurch gekennzeichnet, daß das Abstreif-Lineal (9) ein Haar-Lineal ist.

15. Vorrichtung nach Anspruch 14, dadurch gekennzeichnet, daß das Haar-Lineal (9) im wesentlichen aus einem Rohr mit kreisförmiger Linealkante besteht, das eine rotierende Bewegung um die Matrizenöffnung ausführt.

16. Vorrichtung nach Anspruch 14, dadurch gekennzeichnet, daß das Haar-Lineal (9) aus einem konzentrischen Doppelrohr besteht, bei dem der Abstand der Rohrwandungen klein gegenüber dem Durchmesser ist.

## Claims

1. Method for making piezoceramic membranes, in which powdery ceramic starting materials undergo shaping into a blank, with a thickness:area ratio which is typical for membranes, having a thickness of below 200 μm, and are subsequently sintered by heat treatment, and converted through conversion combustion into the piezoceramic state, said blank being able to be used as a membrane; said method using the following criteria when manufacturing the blank:
– The manufacture occurs by compressing the powdery starting material in a pressing device comprising an extrusion die as well as a lower and upper punch, displaceable relative thereto, whereby

a) a volumetric filling-in of the starting material when the lower punch is lowered and levelling of the powder at a constant height occur,

b) subsequently the layer of the prescribed height of the starting powder is compressed at a prescribed pressure,

c) for removing the membrane blank from the mould the lower punch and upper punch are displaced synchronously in the compressed state, relative to the extrusion die and firstly then the upper and lower punch are moved apart.

2. Method according to claim 1, characterised in that the levelling of the starting material occurs through stripping at least twice in opposing directions.

3. Method according to claim 1, characterised in that the filling-in of the starting material already occurs with constant filling height.

4. Method according to claim 1, characterised in that before the volumetric filling-in of the powder sliding means are applied to the pressing surfaces of the upper punch and lower punch.

5. Method according to claim 1, characterised in that for the pressure-shaping process the filled extrusion die is lowered, the upper punch is then moved up to the die edge and the further conveyance to the pressing position occurs at reduced speed.

6. Method according to claim 1, characterised in that during the pressure-shaping process the pressing pressure lies between 0.5 and 2t/cm² and the pressing time lies between 0.5 and 3 seconds.

7. Method according to claim 6, characterised in that the pressing pressure and the pressing time are synchronised to each other.

8. Method according to claim 1, characterised in that during step b) of the method lifting the upper punch from the membrane occurs at a speed of ≤ 1 mm/s.

9. Device for carrying out the method of manufacturing according to claim 1 or one of claims 2 to 8, with a powder press of an extrusion die and lower punch (6) and upper punch (7), mobile relative to each other, whereby the extrusion die is constructed as a ring die (1) and has a filling device (7), with which a volumetric filling of the ring die (1) is possible at an even height when the lower punch is lowered, and/or has possibly a separate stripper rule (9) for distributing the filled powder.

10. Device according to claim 9, characterised in that the pressing surfaces (15, 16) have a surface roughness of between 4 and 9 µm R_t.

11. Device according to claim 9, characterised in that the pressing surfaces (15, 16) of the upper and lower punch (5, 6) are provided with means for sliding the powder.

12. Device according to claim 11, characterised in that the sliding means are rape oil.

13. Device according to claim 11, characterised in that sliding means are a mechanically resistant material layer.

14. Device according to claim 9, characterised in that the stripper rule (9) is a straight-edge.

15. Device according to claim 14, characterised in that the straight-edge (9) consists substantially of a tube with circular rule edge, which executes a rotating motion around the die opening.

16. Device according to claim 14, characterised in that the straight-edge (9) consists of a concentric double tube, in which the distance of the tube walls is small compared to the diameter.

**Revendications**

1. Procédé de fabrication de membranes piézocéramiques, qui consiste à soumettre des matériaux céramiques de départ, sous forme de poudres, à un façonnage en une ébauche ayant un rapport de l'épaisseur à la surface qui est typique pour des membranes et ayant une épaisseur inférieure à 200 µm et ensuite à les fritter par traitement thermique et à les faire passer, par une cuisson de transformation, à l'état piézocéramique, l'ébauche pouvant être utilisée comme membrane, avec les mesures suivantes lors de la fabrication de l'ébauche:

– la fabrication s'effectue en comprimant le matériau de départ, sous forme de poudre, dans une presse constituée d'une matrice de presse, ainsi que de poinçons inférieur et supérieur pouvant être déplacés par rapport à celle-ci,

a) en effectuant un remplissage volumétrique de la matière de départ, lorsque le poinçon inférieur est abaissé et un aplanissement de la poudre à une hauteur constante,

b) en comprimant ensuite, sous une pression donnée à l'avance, la couche d'une hauteur donnée à l'avance de la poudre de départ,

c) pour démouler l'ébauche de membrane, en déplaçant le poinçon inférieur et le poinçon supérieur en synchronisme par rapport à la matrice de presse et alors qu'ils sont à l'état où ils appliquent une pression et à n'écarter qu'ensuite seulement le poinçon supérieur et le poinçon inférieur.

2. Procédé suivant la revendication 1, caractérisé en ce qu'il consiste à effectuer l'aplanissement de la matière de départ en balayant ou raclant au moins deux fois dans des sens opposés.

3. Procédé suivant la revendication 1, caractérisé en ce qu'il consiste à effectuer le remplissage de la matière de départ en lui donnant déjà une hauteur de remplissage constante.

4. Procédé suivant la revendication 1, caractérisé en ce qu'il consiste à déposer, avant le remplissage volumétrique de la poudre, un agent de démoulage sur les surfaces de pression du poinçon supérieur et du poinçon inférieur.

5. Procédé suivant la revendication 1, caractérisé en ce qu'il consiste à abaisser, pour le processus de compression, la matrice de la presse emplie, à déplacer le poinçon supérieur d'abord jusqu'au bord de la matrice et à effectuer le reste de l'avance jusqu'à la position de compression à une vitesse plus petite.

6. Procédé suivant la revendication 1, caractérisé en ce que, pour un processus de compression, la pression de compression est comprise entre 0,5 et 2 t/cm² et la durée de compression est comprise entre 0,5 et 3 secondes.

7. Procédé suivant la revendication 6, caractérisé en ce qu'il consiste à régler l'une en fonction de l'autre la pression de compression et la durée de compression.

8. Procédé suivant la revendication 1, caractérisé en ce qu'il consiste à effectuer, au stade b) du procédé, le soulèvement du poinçon supérieur de la membrane à une vitesse inférieure à 1 mm/s.

9. Dispositif pour la mise en œuvre du procédé de fabrication suivant la revendication 1 ou l'une des revendications 2 à 8, comprenant une presse à poudre, constituée d'une matrice de presse et de poinçons inférieur 6 et supérieur 7 mobiles l'un par rapport à l'autre, la matrice de presse étant constituée sous la forme d'une matrice annulaire (1) et comportant un dispositif de remplissage (7), rendant possible un remplissage volumétrique de la matrice annulaire (1) à une hauteur uniforme lorsque le poinçon inférieur est abaissé, et/ou une réglette de balayage (9) éventuellement distincte pour répartir la poudre introduite.

10. Dispositif suivant la revendication 9, caractérisé en ce que les surfaces d'application d'une pression (15, 16) ont une rugosité superficielle comprise entre 4 et 9 μm $R_t$.

11. Dispositif suivant la revendication 9, caractérisé en ce que les surfaces d'application d'une pression (15, 16) du poinçon supérieur (5) et du poinçon inférieur (6) sont munies d'agents de démoulage de la poudre.

12. Dispositif suivant la revendication 11, caractérisé en ce que l'agent de démoulage est de l'huile de navette.

13. Dispositif suivant la revendication 11, caractérisé en ce que l'agent de démoulage est une couche de substance dure.

14. Dispositif suivant la revendication 9, caractérisé en ce que la réglette de balayage (9) est une réglette de précision.

15. Dispositif suivant la revendication 14, caractérisé en ce que la réglette de précision (9) est constituée essentiellement d'un tube à bord circulaire droit formant réglette et effectuant un mouvement de rotation autour de l'ouverture de la matrice.

16. Dispositif suivant la revendication 14, caractérisé en ce que la réglette de précision (9) est constituée d'un tube double, concentrique, dans lequel la distance entre les parois des tubes est petite par rapport au diamètre.

FIG 1

FIG 2

FIG 3

FIG 4

FIG 5